# EUROPEAN PATENT APPLICATION

(11) **EP 1 855 314 A1**
(43) Date of publication of application: **14.11.2007**
(21) Application number: 07107488.4
(22) Date of filing: 04.05.2007
(51) Int. Cl.: H01L 21/677, B65G 49/07

(54) **Cassette conveyance method and cassette conveyance apparatus**

(30) Priority: 12.05.2006 JP 2006133985
(71) Applicant: TOKYO SEIMITSU CO., LTD., Mitaka-shi Tokyo (JP)
(72) Inventor: Kawashima, Isamu, Mitaka-shi Tokyo (JP); Sato, Hideshi, Mitaka-shi Tokyo (JP); Kino, Hideo, Mitaka-shi Tokyo (JP); Ametani, Minoru, Mitaka-shi Tokyo (JP)
(74) Representative: Skone James, Robert Edmund

(57) **Abstract**

A cassette conveyance apparatus (10) includes: a first conveyance means (20) for conveying a first cassette (40) in a horizontal and vertical direction; and a second conveyance means (30) for conveying a second cassette (50) in a horizontal and vertical direction . In the cassette conveyance apparatus (10), the first and second cassettes are circulated between a predetermined wafer accommodation position (P1), at which a wafer (2) is accommodated in the cassette, and a predetermined cassette replacement position (P0) at which a cassette accommodating a plurality of wafers is replaced with an empty cassette. Due to the foregoing, the wafers are continuously accommodated in the cassette without stopping an operation of a pretreatment step.

## Description

The present invention relates to a cassette conveyance method for conveying cassettes, in which a plurality of wafers are accommodated, in the field of manufacturing semiconductor devices. The present invention also relates to a cassette conveyance apparatus in which this cassette conveyance method is executed.

In the field of manufacturing semiconductors, there is a tendency for large-sized wafers to be used year after year. Further, in order to enhance the packing density, the wafer thickness has been reduced. In order to reduce the wafer thickness, back-grinding the surfaces of wafers is carried out. After back-grinding is finished, a dicing tape is adhered to the back surface of each wafer, so that the wafer can be integrated with a mount frame into one body.

After that, a surface protective film, which has been previously adhered onto the front surface of the wafer, is peeled. Then, an ID number formed on the surface of each wafer is read. After a bar code label corresponding to the ID number is adhered, the wafer is accommodated in a cassette (refer to Japanese Patent Application No. 2006-35259). Japanese Unexamined Patent Publication No. 5-82625 discloses a technique in which a wafer, which has already been subjected to predetermined processing although the wafer is not integrated with a mount frame into one body, is accommodated in a cassette.

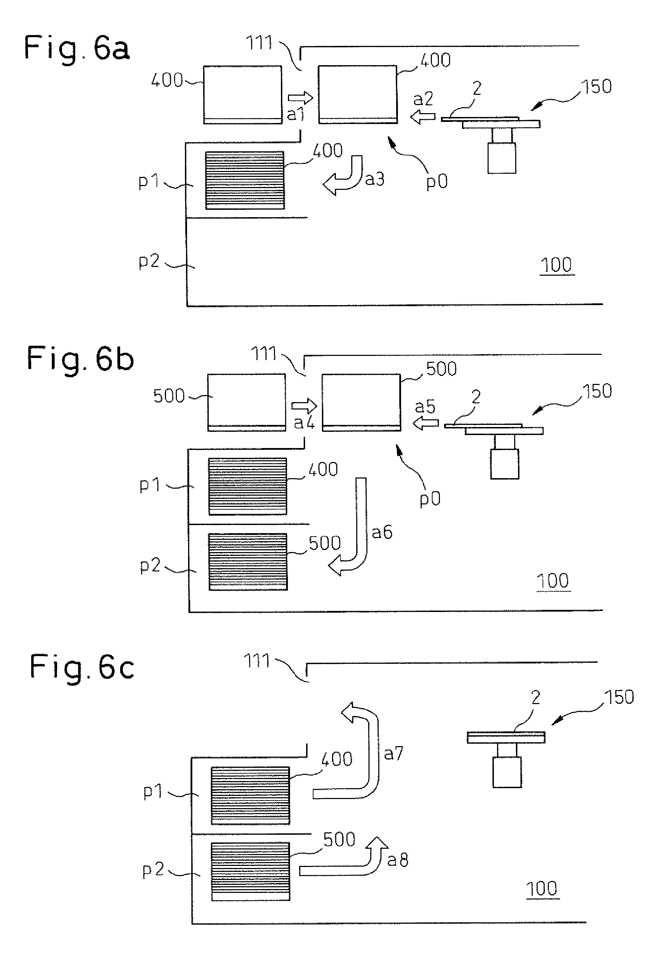

Figs. 6a to 6c are sectional schematic illustrations showing actions of cassettes of the prior art, for example described in Japanese Patent Application No. 2006-35259. As shown by arrow a1 in Fig. 6a, a first cassette 400 is conveyed to a predetermined position p0 in a processing device 100 through an opening portion 111 of the processing device 100 by a conveyance means (not shown).

On the other hand, a wafer 2, on which final processing has been conducted in a processing unit 150 of the processing device 100, for example, on which a bar code label has been adhered, is accommodated in a first cassette 400 by a robot hand (not shown) as shown by arrow a2. The first cassette 400 is lowered by a predetermined distance each time one wafer 2 is accommodated in the first cassette, and the next wafer 2 is successively accommodated in the first cassette. The first cassette 400, in which a predetermined number of wafers 2 are accommodated, is lowered to a predetermined position. Then, the first cassette 400 is conveyed in the horizontal direction and temporarily stocked at first stock position p1 (refer to arrow a3).

Next, as shown in Fig. 6b, a second cassette 500 is conveyed to predetermined position p0 through an opening portion 111. In the same manner as that of the first cassette 400, in the second cassette 500, the wafers 2 are accommodated. Then, the first cassette 400 is conveyed to second stock position p2 located at a lower position of first stock position p1 (refer to arrows a4 and a5).

After the cassettes 400, 500 are charged at two stock positions p1, p2 respectively, the processing unit 150 is stopped. Then, as shown by arrow a7 in Fig. 6c, the first cassette 400 is discharged outside the processing device 100 through the opening portion 111. As shown by arrow a8, the second cassette 500 is discharged outside the processing device 100 in the same manner as that of the first cassette 400. After these two cassettes 400, 500 have been discharged, a new empty cassette is conveyed to a predetermined position p0. After the processing unit 150 is started again, the wafer 2 is accommodated in the new cassette in the same manner as that described above.

However, in the case where the wafers 2 are accommodated in both the first cassette 400 and the second cassette 500 in the cassette conveyance action of the prior art shown in Figs. 6a and 6c, before the new cassette is used, it is necessary to stop the processing unit 150 and pick up the two cassettes 400, 500 from the processing device 100.

That is, it is necessary to stop the operation of the processing unit 150 during a period of time from when the wafers 2 have been accommodated in the second cassette 500 to when the new cassette is conveyed to predetermined position P0. Accordingly, processing of the wafers 2 is delayed due to the stoppage of operation of the processing unit 150. Recently, in the field of manufacturing semiconductors, high production capacity is required. Therefore, it is desirable to avoid the delay of the processing time described above.

The present invention has been accomplished in view of the above circumstances. It is an object of the present invention to provide a cassette conveyance method in which wafers can be continuously accommodated in a cassette without stopping an operation of a pretreatment step. It is another object of the present invention to provide a cassette conveyance apparatus in which this cassette conveyance method is executed.

### SUMMARY OF THE INVENTION

In order to accomplish the above object, according to the first embodiment, a cassette conveyance apparatus comprises: a first conveyance means for conveying a first cassette in the horizontal and the vertical direction; and a second conveyance means for conveying a second cassette in the horizontal and the vertical direction, wherein the first and the second cassette are circulated by the first and the second conveyance means between a workpiece accommodation position, at which a workpiece is accommodated in the cassette, and a cassette replacement position at which the cassette accommodating a plurality of workpieces is replaced with an empty cassette.

In the first embodiment, when one cassette is arranged at the workpiece accommodation position, the other cassette is replaced at the cassette replacement position. After accommodation has finished for one cassette, a new cassette, which has been replaced, is conveyed to the workpiece accommodation position, so that workpieces, for example, wafers can be continuously accommodated. Due to the foregoing, without stopping an operation of a pretreatment step, the workpieces, for example, wafers can be continuously accommodated.

According to the second embodiment, as in the cassette conveyance apparatus of the first embodiment, the first conveyance means includes: a first horizontal rail; a first horizontal slider sliding on the first horizontal rail; a first vertical rail attached to the first horizontal slider; a first vertical slider sliding on the first vertical rail; and a first table, which is attached to the first vertical slider, on the top face of which the first cassette is arranged, and the second conveyance means includes: a second horizontal rail arranged in parallel with the first horizontal rail; a second horizontal slider sliding on the second horizontal rail; a second vertical rail attached to the second horizontal slider; a second vertical slider sliding on the second vertical rail; and a second table, which is attached to the second vertical slider, on the top face of which the second cassette is arranged.

That is, in the second embodiment, it is possible to compose the first and the second conveyance means by a relatively simple configuration.

According to the third embodiment, as in the second embodiment, the first table extends toward the second horizontal rail, the second table extends toward the first horizontal rail, and the first and the second table can be at least partially overlapped with each other on a face vertical to the first and the second horizontal rail.

That is, in the third embodiment, it is possible to reduce the width of the cassette conveyance apparatus by a portion where the first and the second table are overlapped with each other.

According to the fourth embodiment, as in the third embodiment, distances, by which the first and the second table extend from the vertical sliders corresponding to the first and the second table, are a little shorter than the distance between the first and the second horizontal rail.

Therefore, according to the fourth embodiment, the width of the cassette conveyance apparatus can be minimized.

According to the fifth embodiment, as in one of the second to the fourth embodiments, lengths of the first and the second vertical rail are set in such a manner that the second table and the second cassette can pass through under the first table when the first vertical slider is located at the lowermost position of the first vertical rail and when the second vertical slider is located at the uppermost position of the second vertical rail.

Therefore, according to the fifth embodiment, the cassettes are conveyed in such a manner that the one cassette can pass through above the other cassette. Therefore, it is possible to convey the first and the second cassette at the same time.

According to the sixth embodiment, as in one of the second to the fourth embodiments, lengths of the first and the second vertical rail are set at the minimum values in such a manner that the second table and the second cassette can pass through under the first table when the first vertical slider is located at the lowermost position of the first vertical rail and when the second vertical slider is located at the uppermost position of the second vertical rail.

Therefore, according to the sixth embodiment, lengths of the first and the second vertical rail can be minimized.

According to the seventh embodiment, a cassette conveyance method comprises: a first accommodation step in which a workpiece is accommodated in a first cassette at a workpiece accommodation position for accommodating the workpiece in the cassette; a first conveyance step in which the first cassette is conveyed to a cassette replacement position at which a cassette accommodating a plurality of workpieces is replaced with an empty cassette and in the first conveyance step the second cassette replaced at the cassette replacement position is conveyed to the workpiece accommodation position; a second accommodation step in which the workpiece is accommodated in the second cassette at the workpiece accommodation position; and a second conveyance step in which the second cassette accommodating a plurality of workpieces is conveyed to the cassette replacement position and in the second conveyance step the first cassette replaced at the cassette replacement position is conveyed to the workpiece accommodation position, wherein the first accommodation step, the first conveyance step, the second accommodation step and the second conveyance step are repeated.

That is, in the seventh embodiment, when one cassette is being arranged at the workpiece accommodation position, the other cassette is replaced at the cassette replacement position. After the accommodation has been finished for one cassette, the new cassette, which has been replaced, is conveyed to the workpiece accommodation position, for example, so that the workpiece continuously accommodate the wafer. Due to the foregoing, without stopping an operation of the pretreatment step, for example, the workpieces, wafers can be continuously accommodated in the cassette.

According to the eighth embodiment, as in the seventh embodiment, the cassette is lowered by a predetermined distance each time the cassette accommodates one workpiece at the workpiece accommodation position, the cassette accommodating all of the plurality of workpieces is located at a position lower than the workpiece accommodating position, and in the first and the second conveyance steps, one cassette of the first and the second cassette conveyed from the cassette replacement position to the workpiece accommodation position passes above the other cassette conveyed from the workpiece accommodation position to the cassette replacement position.

Therefore, according to the eighth embodiment, one cassette can pass above the other cassette. Therefore, it is possible to reduce the size needed for executing the cassette conveyance method. Due to the foregoing, it is possible to convey both cassettes at the same time.

According to the ninth embodiment, as in the eighth embodiment, the first and the second conveyance steps include a process in which the other cassette is raised.

That is, the ninth embodiment is advantageous especially when the workpiece accommodation position and the cassette replacement position are located on substantially the same plane.

These and other objects, features and advantages of the present invention will be more apparent in light of the detailed description of exemplary embodiments thereof as illustrated by the drawings.

In the drawings:
Fig. 1 is a side view showing a cassette conveyance apparatus according to the present invention;
Fig. 2 is a plan view showing the cassette conveyance apparatus shown in Fig. 1;
Fig. 3 is a partial enlarged front view showing the cassette conveyance apparatus shown in Fig. 1;
Fig. 4 is a flow chart showing an operation of the cassette conveyance apparatus of the present invention;
Fig. 5a is a first sectional schematic illustration showing an operation of the cassette conveyance apparatus of the present invention;
Fig. 5b is a second sectional schematic illustration showing an operation of the cassette conveyance apparatus of the present invention;
Fig. 5c is a third sectional schematic illustration showing an operation of the cassette conveyance apparatus of the present invention;
Fig. 5d is a fourth sectional schematic illustration showing an operation of the cassette conveyance apparatus of the present invention;
Fig. 6a is a first sectional schematic illustration showing a conveyance operation of conveying a cassette of the prior art;
Fig. 6b is a second sectional schematic illustration showing a conveyance operation of conveying a cassette of the prior art; and
Fig. 6c is a third sectional schematic illustration showing a conveyance operation of conveying a cassette of the prior art.

Referring to the accompanying drawings, an embodiment of the present invention will be explained below. Similar reference numerals are used to indicate similar parts in the following drawings. In order to facilitate the understanding, the scale of these drawings has been changed appropriately.

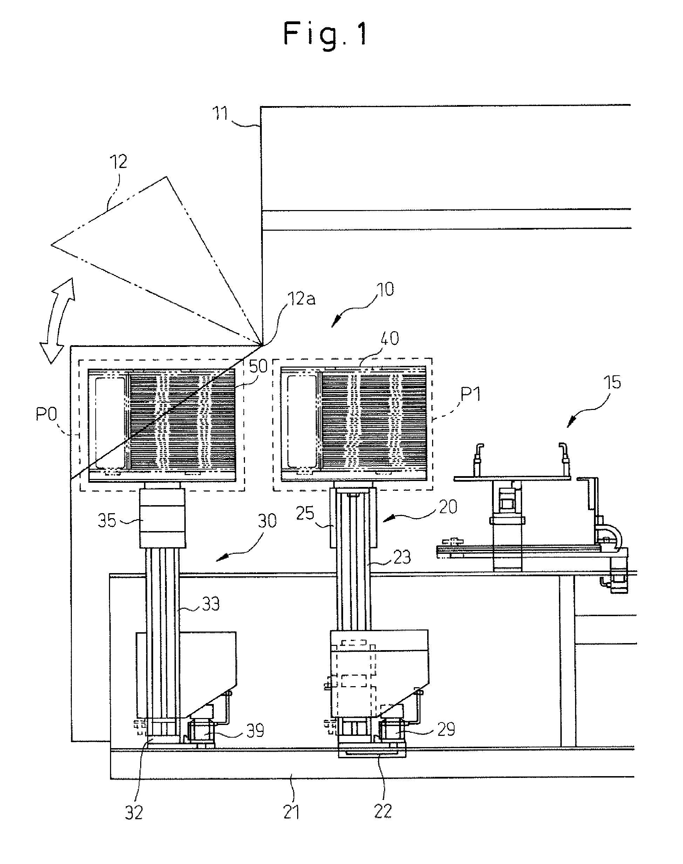

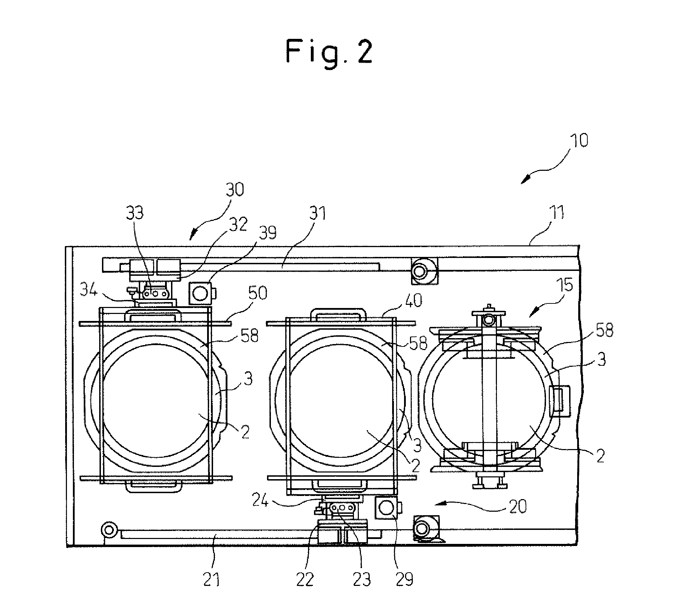

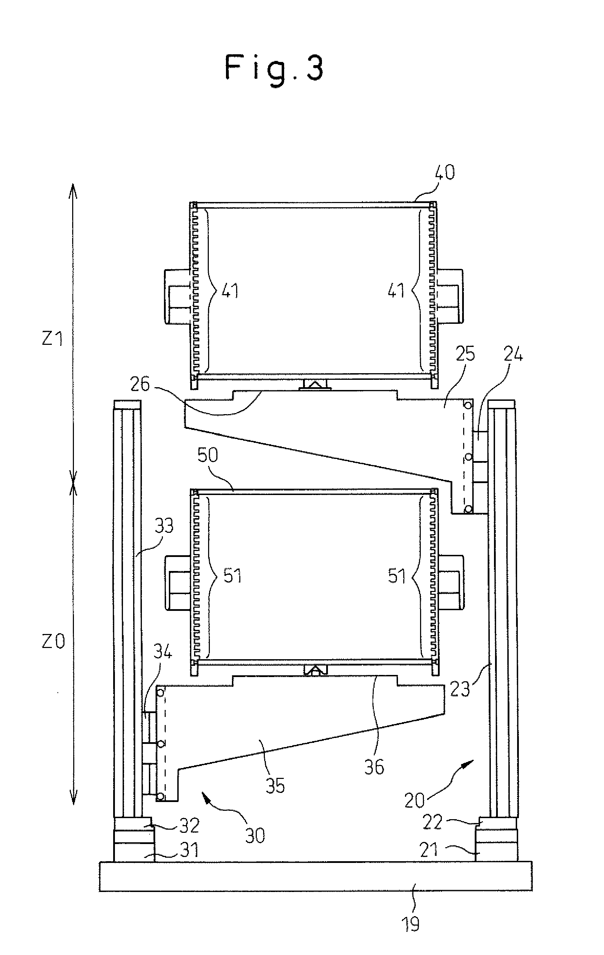

Fig. 1 is a side view showing a cassette conveyance apparatus according to the present invention. Figs. 2 and 3 are a plan view and a partial enlarged front view showing the cassette conveyance apparatus shown in Fig. 1, respectively. As shown in these drawings, the cassette conveyance apparatus 10 of the present invention includes: a first conveyance means 20 for conveying a first cassette 40 in the vertical and the horizontal direction; and a second conveyance means 30 for conveying a second cassette 50 in the vertical and the horizontal direction. These conveyance actions are conducted by motors 29, 39 arranged in the first conveyance means 20 and the second conveyance means 30.

As shown in Fig. 1, on the housing 11 of the cassette conveyance apparatus 10, a lid portion 12 is pivotably arranged around a shaft portion 12a. As shown in Fig. 1, a processing unit 15 is arranged on the right of the cassette conveyance apparatus 10. The processing unit 15 can conduct predetermined processing on a wafer 2, for example, the processing unit 15 can adhere a bar code label (not shown) on the wafer 2. However, a processing unit 15 for conducting another processing may be arranged.

In the present invention, a back surface of the wafer 2 supplied to the processing unit 15 is ground. Therefore, the thickness of the wafer 2 is greatly reduced. On the back surface of the wafer 2, a dicing tape 3 is adhered, and the wafer 2 is integrated with a mount frame 58 into one body. When the wafer 2 is supplied to the processing unit 15, a surface protective film, which was adhered to the front surface of the wafer 2, has already been peeled. In this connection, in an embodiment not shown in the drawing, a wafer 2, which is not integrated with the mount frame 58, but subjected to another processing, may be supplied to the processing unit 15.

As shown in Fig. 3, the first conveyance means 20 includes a first horizontal rail 21 extending in the horizontal direction. A first horizontal slider 22 slides on the first horizontal rail 21. To the first horizontal slider 22, a first vertical rail 23 extending in the vertical direction is attached. On this first vertical rail 23, a first vertical slider 24 is slid. A bracket type first table 25, on the top face 26 of which a first cassette 40 can be arranged, extends in the horizontal direction from the first vertical slider 24.

In the same manner, the second conveyance means 30 includes a second horizontal rail 31 extending parallel to the first horizontal rail 21. A second horizontal slider 32 slides on the second horizontal rail 31. To the second horizontal slider 32, a second vertical rail 33 extending in the vertical direction is attached. On this second vertical rail 33, a second vertical slider 34 is slid. A bracket type second table 35, on the top face 36 of which a second cassette 50 can be arranged, extends in the horizontal direction from the second vertical slider 34.

As can be seen from Figs. 2 and 3, the first table 25 extends in a direction from the first vertical slider 24 to the second horizontal rail 31, and the second table 35 extends in a direction from the second vertical slider 34 to the first horizontal rail 21. The sizes of the first 25 and second tables 35 are sufficiently large for arranging the first 40 and second cassettes 50, respectively, on the top faces of the tables.

In the embodiment shown in Figs. 2 and 3, the distances of the extensions of the first 25 and second tables 35 are a little shorter than the distance between the first rail 21 and second horizontal rails 31. Accordingly, in the present embodiment, the width of the cassette conveyance apparatus 10 can be minimized.

As can be seen from Fig. 3, when the first table 25 is located at the uppermost position of the first vertical rail 23 and the second table 35 is located at the lowermost position of the second vertical rail 33, a gap, in which the second cassette 50 can pass through, is formed between the first table 25 and the second table 35. This gap shown in Fig. 3 is the minimum size necessary for the second cassette 50 to pass through the gap. In this case, the lengths of the first rail 23 and second vertical rails 33 are minimized. That is, in this case, the height of the cassette conveyance apparatus 10 can be minimized.

As shown in Fig. 3, on the inner faces of the respective side portions of the first 40 and second cassette 50, a plurality of slits 41, 51, which are opposed to each other, are formed. The distance between the slits, which are opposed to each other, is substantially the same as the outer diameter 58 of the mount frame 58, which is integrated with the wafer 2. However, in the case of an embodiment in which the mount frame 58 is not used, the distance between the slits, which are opposed to each other, is substantially the same as the outer diameter of the wafer 2.

Referring to Fig. 1 again, the first cassette 40 is positioned at the uppermost position of the first vertical rail 23. As shown in the drawing, this position P1 is adjacent to the processing unit 15. At this position P1, the wafer 2, which has been processed by the processing unit 15, is conveyed from the processing unit 15 to the first cassette 40 by a robot hand (not shown in the drawing) and accommodated into the slit 41 formed in the first cassette 40. Position P1 at which the wafer 2 can be accommodated in the cassette will be referred to as the wafer accommodation position P1 hereinafter.

In Fig. 1, the second cassette 50 is positioned at the uppermost position of the second vertical rail 33. This position P0 is at the same height as that of the wafer accommodation position P1 and located on the left of the wafer accommodation position P1. As can be seen from Fig. 1, the cassette arranged at this position P0 can be picked up from the cassette conveyance apparatus 10 when the lid portion 12 is opened. Then, another cassette (not shown) can be set on the table. This position P0, at which the cassette can be replaced with another cassette, will be referred to as cassette replacement position P0 hereinafter.

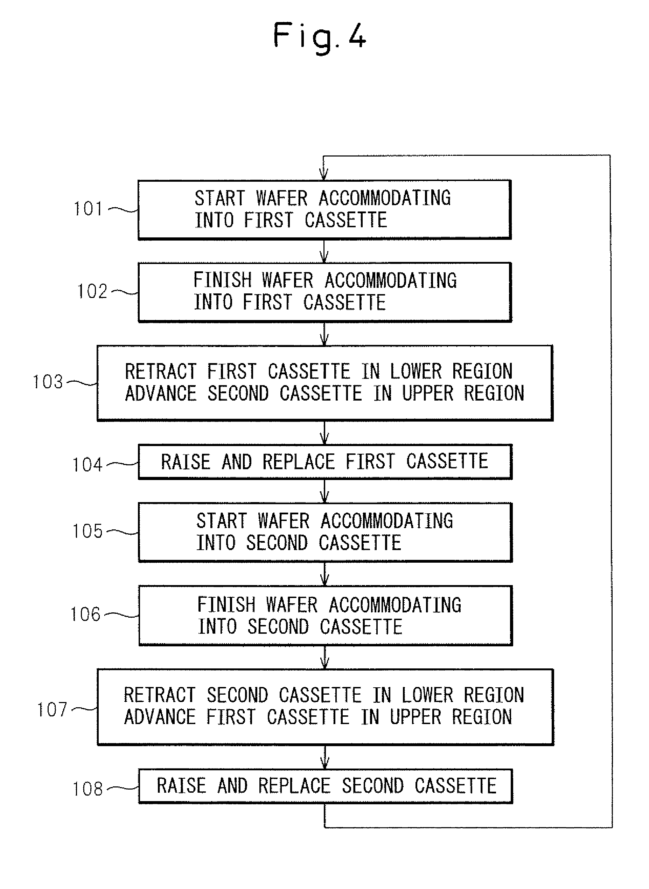

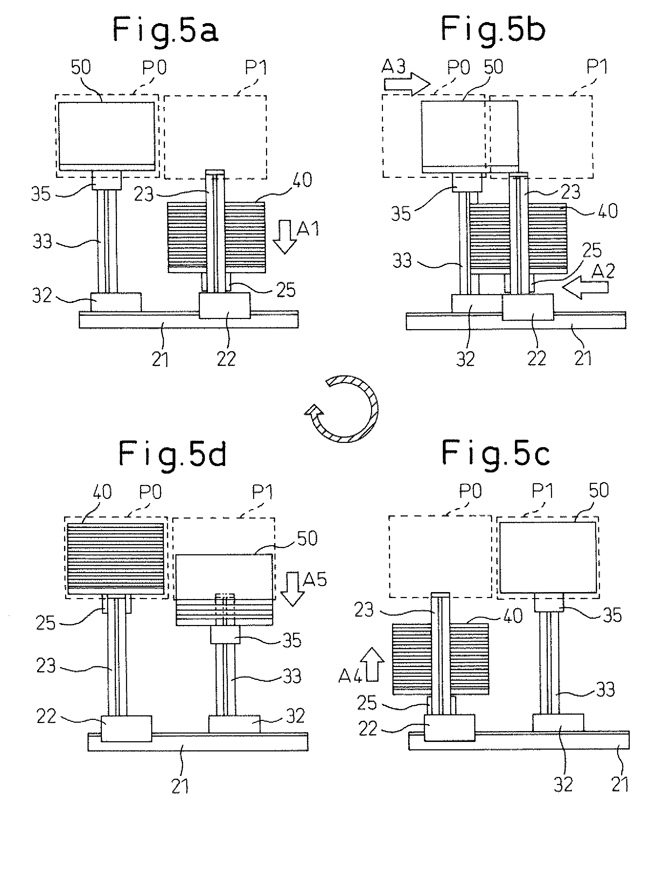

Although not shown in Fig. 1 and the other drawings, the cassette conveyance apparatus 10 includes a control unit connected to the first conveyance means 20 and the second conveyance means 30. The control unit controls the cassette conveyance apparatus 10 according to the flow of operation as showing Fig. 4, and also according to the operation of the cassette conveyance apparatus 10 as shown in Figs. 5a to 5d.

Referring to Fig. 4 and Figs. 5a to 5d, the operation of the cassette conveyance apparatus 10 of the present invention will be explained below. In this connection, at the initial stage of operation of the cassette conveyance apparatus 10, as shown in Fig. 1, both the first 40 and second cassettes 50 are empty and respectively arranged at the wafer accommodation position P1, and the cassette replacement position P0. Further, the lid portion 12 of the housing 11 is closed.

In step 101 shown in Fig. 4, the processing unit 15 and the related robot arm are started so as to convey the wafer 2 from the processing unit 15 to the first cassette 40. The wafer 2 is accommodated in the lowermost slit 41 in the first cassette 40.

The first vertical slider 24 of the first table 25, which supports the first cassette 40, is lowered along the first vertical rail 23 by a distance corresponding to one slit 41 and stops at the position. Due to the foregoing, the wafer 2, which has been successively processed by the processing unit 15, is accommodated in the slit 41, which is arranged just above the lowermost slit.

Then, the first table 25 is lowered by a distance corresponding to one slit 41 and the next wafer 2 is accommodated (refer to arrow A1 in Fig. 5a). By repeating this operation, a plurality of wafers 2 are successively accommodated in a plurality of slits 41 in the first cassette 40. When the wafers 2 are accommodated in all of the slits 41 in step 102, the accommodation operation in the first cassette 40 is finished.

Since the first cassette 40 is lowered by a predetermined distance each time one wafer 2 is accommodated in the first cassette 40, when the accommodation operation is finished in the first cassette 40, the first cassette 40 is located at a position lower than the second table 35 of the second cassette 50 located at the cassette replacement position P0 (refer to Fig. 5a).

As can be seen from Fig. 3, in the specification of this patent application, the region containing the cassette located at the uppermost position of the first vertical rail 23 (or the second vertical rail 33) is referred to as upper region Z1. Further, the region located at a position lower than the table of the cassette located in upper region Z1 is referred to as lower region Z0.

Next, as shown by arrow A2 in Fig. 5b, the first horizontal slider 22 is slid to the left along the first horizontal rail 21. Due to the foregoing, the first cassette 40 is retracted to the lower region Z0 (step 103). That is, the first cassette 40 is conveyed away from the wafer accommodation position P1.

At the same time, as shown by arrow A3, the second horizontal slider 32 is slid to the right along the second horizontal rail 31. Due to the foregoing, the second cassette 50 is advanced to upper region Z1. That is, in this case, the second cassette 50 is conveyed from the cassette replacement position P0 to the wafer accommodation position P1.

When the second cassette 50 has arrived at the wafer accommodation position P1, the first cassette 40 is located right below the cassette replacement position P0. As shown by arrow A4 in Fig. 5c, the first vertical slider 24 of the first cassette 40 is raised along the first vertical rail 23 (step 104). Due to the foregoing, the first cassette 40 can be conveyed to the cassette replacement position P0.

After that, the lid portion 12 is opened and the first cassette 40 is picked up from the cassette conveyance apparatus 10. Another empty cassette 40 (not shown) is arranged on the second table 35. The first cassette 40 (or the second cassette 50) may be manually picked up and replaced by an operator. Alternatively, the first cassette 40 may be automatically picked up and replaced by a robot.

After the first cassette 40 has been raised in step 104 or simultaneously when the first cassette 40 has been raised in step 104, the second cassette 50 starts accommodating the wafer 2 in step 105. In this case, in the same manner as that of the first cassette 40, each time a wafer 2 is accommodated, the second cassette 50 is lowered by a predetermined distance (refer to arrow A5 in Fig. 5d).

when all of the plurality of wafers 2 are accommodated in the second cassette 50, that is, when the second cassette 50 finishes accommodating the wafers 2, the second cassette 50 is lowered to lower region Z0.

Although not shown in the drawing, the second horizontal slider 32 is slid to the left along the second horizontal rail 31 in step 107. Due to the foregoing, the second cassette 50 is retracted in lower region Z0. At the same time, the first horizontal slider 22 is slid to the right along the first horizontal rail 21. Due to the foregoing, the second cassette 50 is advanced in upper region Z1. Then, in step 108, the second vertical slider 34 is raised along the second vertical rail 33 and conveyed to the cassette replacement position P0. In this way, the cassette is replaced with another second cassette 50.

Next, the program is returned to step 101 and wafers 2 are successively accommodated in the first cassette 40, which has arrived at the wafer accommodation position P1. After that, steps 101 to 108 described above are repeated.

In the present invention, the first cassette 40 and the second cassette 50 are alternately circulated between the wafer accommodation position P1 and the cassette replacement position P0. When one cassette is arranged at the wafer accommodation position P1, the other cassette can be picked up and/or replaced at the cassette replacement position P0. When the other cassette is arranged at the wafer accommodation position P1, one cassette can be picked up and/or replaced at the cassette replacement position P0.

In the cassette conveyance apparatus 10 of the present invention, the wafer 2 can always be accommodated in either of the two cassettes. Accordingly, in the present invention, it is not necessary to stop the processing unit 15, which is the pretreatment step. Therefore, in the present invention, there is no delay in time since the processing unit 15 is not stopped. Consequently, it is possible to exhibit a high production capacity.

In the embodiment described above, both the wafer accommodation position P1 and the cassette replacement position P0 are located in upper region Z1. However, in the case where either the wafer accommodation position P1 or the cassette replacement position P0 is located at another position, for example, in the case where either the wafer accommodation position P1 or the cassette replacement position P0 is located in lower region Z0, the same effect can be obtained by using the cassette conveyance apparatus 10 of the present invention.

Further, in the embodiment described above, for example, the first conveyance means 20 includes: a first horizontal rail 21, a first horizontal slider 22, a first vertical rail 23, a first vertical slider 24 and a first table 25. However, another conveyance means capable of conveying the first cassette 40 (and the second cassette 50) in the horizontal and the vertical direction may be employed. The above case is included in the scope of the present invention.

Furthermore, in the embodiment explained above referring to the drawings, region Z1, in which one cassette is conveyed, is located at a position higher than region Z0 in which the other cassette is conveyed. However, regions Z1 and Z0, in which the cassette is conveyed, may be located on the same plane. In this case, the second cassette 50 is shown on the right or the left of the first cassette 40, which is being conveyed in Fig. 3. This case is also included in the scope of the present invention.

In the embodiment explained above, the cassette, in which the wafer 2 integrated with the mount frame 58 is accommodated, is conveyed. However, the cassette conveyance apparatus and the cassette conveyance method of the present invention can be applied to a case in which the cassette for accommodating only the wafer 2 is conveyed. In other words, the cassette conveyance apparatus of the present invention may be incorporated into another apparatus. For example, the cassette conveyance apparatus of the present invention may be incorporated into a adhering device in which a surface protective tape is adhered on a surface of the wafer 2. Alternatively, the cassette conveyance apparatus of the present invention may be incorporated into a peeling device in which a surface protective tape adhered onto the surface of the wafer 2 is peeled.

## Claims

1. A cassette conveyance apparatus comprising: a first conveyance means for conveying a first cassette in a horizontal and vertical direction; and a second conveyance means for conveying a second cassette in a horizontal and vertical direction, wherein the first and the second cassettes are circulated by the first and second conveyance means between a workpiece accommodation position, at which a workpiece is accommodated in the cassette, and a cassette replacement position at which the cassette accommodating a plurality of workpieces is replaced with an empty cassette.

2. A cassette conveyance apparatus according to claim 1,
the first conveyance means including: a first horizontal rail; a first horizontal slider sliding on the first horizontal rail; a first vertical rail attached to the first horizontal slider; a first vertical slider sliding on the first vertical rail; and a first table, which is attached to the first vertical slider, on the top face of which the first cassette is arranged, and
the second conveyance means including: a second horizontal rail arranged in parallel with the first horizontal rail; a second horizontal slider sliding on the second horizontal rail; a second vertical rail attached to the second horizontal slider; a second vertical slider sliding on the second vertical rail; and a second table, which is attached to the second vertical slider, on the top face of which the second cassette is arranged.

3. A cassette conveyance apparatus according to claim 2, wherein
the first table extends toward the second horizontal rail,
the second table extends toward the first horizontal rail, and
the first and the second table can be at least partially overlapped with each other on a face vertical to the first and the second horizontal rail.

4. A cassette conveyance apparatus according to claim 3, wherein distances, by which the first and the second table extend from the vertical sliders corresponding to the first and the second table, are shorter than the distance between the first and the second horizontal rail.

5. A cassette conveyance apparatus according to any one of claims 2 to 4, wherein the lengths of the first and the second vertical rails are set in such a manner that the second table and the second cassette can pass under the first table when the first vertical slider is located at the lowermost position of the first vertical rail and when the second vertical slider is located at the uppermost position of the second vertical rail.

6. A cassette conveyance apparatus according to any one of claims 2 to 4, wherein the lengths of the first and the second vertical rails are set at minimum values in such a manner that the second table and the second cassette can pass under the first table when the first vertical slider is located at the lowermost position of the first vertical rail and when the second vertical slider is located at the uppermost position of the second vertical rail.

7. A cassette conveyance method comprising:
a first accommodation step in which a workpiece is accommodated in a first cassette at a workpiece accommodation position for accommodating the workpiece in the cassette;
a first conveyance step in which the first cassette is conveyed to a cassette replacement position at which a cassette accommodating a plurality of workpieces is replaced with an empty cassette and in the first conveyance step the second cassette replaced at the cassette replacement position is conveyed to the workpiece accommodation position;
a second accommodation step in which the workpiece is accommodated in the second cassette at the workpiece accommodation position; and
a second conveyance step in which the second cassette accommodating a plurality of workpieces is conveyed to the cassette replacement position and in the second conveyance step the first cassette replaced at the cassette replacement position is conveyed to the workpiece accommodation position, wherein
the first accommodation step, the first conveyance step, the second accommodation step and the second conveyance step are repeated.

8. A cassette conveyance method according to claim 7, wherein the cassette is lowered by a predetermined distance each time the cassette accommodates one workpiece at the workplace accommodation position,
the cassette accommodating all of the plurality of workpieces is located at a position lower than the workpiece accommodating position, and
in the first and the second conveyance step, the one cassette of the first and the second cassettes conveyed from the cassette replacement position to the workpiece accommodation position passes above the other cassette conveyed from the workpiece accommodation position to the cassette replacement position.

9. A cassette conveyance method according to claim 8, wherein the first and the second conveyance step include a process in which the other cassette is raised.
